# EUROPÄISCHE PATENTSCHRIFT

(11) **EP 1 924 131 B1**
(45) Veröffentlichungstag und Bekanntmachung des Hinweises auf die Patenterteilung: **23.12.2009**
(21) Anmeldenummer: 07009493.3
(22) Anmeldetag: 11.05.2007
(51) Int. Cl.: H05K 7/20

(54) **Betriebs-, Lager- und Transportbehälter für IT-Geräte**
Operating, storage and transport container for IT equipment
Support de fonctionnement, de stockage et de transport pour appareils informatiques

(30) Priorität: 30.08.2006 DE 102006040696
(43) Veröffentlichungstag der Anmeldung: 21.05.2008
(73) Patentinhaber: Thales Defence Deutschland GmbH, 75117 Pforzheim (DE)
(72) Erfinder: Staib, Rüdiger, 75180 Pforzheim (DE); Vennemann, Heinz, 75331 Engelsbrand (DE); Fischer, Bernhard, 76316 Malsch (DE); Schill, Rolf, 75305 Neuenbürg (DE)
(74) Vertreter: Dreiss

(56) Entgegenhaltungen:
- EP-A- 0 560 191

## Beschreibung

Die vorliegende Erfindung betrifft einen Betriebs, Lager- und Transportbehälter für Informationstechnologie (IT)-Geräte. Der Behälter umfasst:
- ein verschließbares Gehäuse mit mindestens einem abnehmbaren Deckel,
- in dem Gehäuse angeordnete Aufnahmemittel für die IT-Geräte und
- eine Klimaanlage zur Erzeugung und Aufrechterhaltung eines gleichmäßigen Klimas im Inneren des Behälters, wobei
- die Klimaanlage eine mit der Umgebung des Behälters in Luftaustausch stehende Außeneinheit mit einem Kondensator und einem Kompressor und eine mit dem Innenraum des Behälters in Luftaustausch stehende Inneneinheit mit einem Verdampfer aufweist, wobei die Außeneinheit über einen Kühlmittelschlauch mit der Inneneinheit verbunden ist, um eine Zirkulation von Kühlmittel zwischen Außeneinheit und Inneneinheit zu ermöglichen,

Derartige Behälter sind bspw. aus der EP 0 560 191 A1 bekannt. Sie werden überall dort benötigt, wo innerhalb relativ kurzer Zeit an beliebigen Orten eine vollständige IT-Netzwerkstruktur aufgebaut und betrieben werden muss. Das ist im zivilen Bereich zum Beispiel bei einem mobilen Rechenzentrum der Fall, welches nach einem Ausfall eines stationären Rechenzentrums (bspw. aufgrund eines Feuers oder Erdbebens) dieses temporär ersetzen muss. Dabei ist es wichtig, dass das mobile Rechenzentrum schnell und ohne Beschädigung vor Ort gelangt und innerhalb kürzester Zeit in Betrieb genommen werden kann. Im militärischen Bereich werden Betriebs, Lager- und Transportbehälter zum Beispiel vom Militär eingesetzt, um für eine IT-Netzwerkstruktur benötigte IT-Geräte möglichst schnell und unbeschädigt in ein entferntes Einsatzgebiet transportieren und dort innerhalb kürzester Zeit eine Netzwerkstruktur für ein Feldlazarett oder ein Flüchtlingslager errichten und betreiben zu können. Das Transportieren von IT-Geräten für eine IT-Netzwerkstruktur in Betriebs, Lager- und Transportbehältern ist aber auch für andere Personengruppen von Bedeutung, bspw. Polizei, Feuerwehr, Bundesgrenzschutz und Technisches Hilfswerk, um nur einige Beispiele zu nennen.

Die Behälter weisen im Inneren Aufnahmemittel in Form eines Rahmens, vorzugsweise eines 19"-Rahmens mit Auflaufschienen auf, auf welchen die verschiedenen IT-Geräte eingeschoben und befestigt werden können. Der Rahmen ist über Schwingungsdämpfer an dem Gehäuse befestigt, um die IT-Geräte während des Transports vor Beschädigung aufgrund harter Stöße zu schützen. IT-Geräte, die in dem Behälter angeordnet werden, sind bspw. eine unterbrechungsfreie Stromversorgung (USV) als Einheit oder unterteilt in Steuereinheit und Akkueinheit, ein Datenkomprimierer (zum Komprimieren und wahlweise Verschlüsseln der zu übertragenden Daten), ein Medienwandler (zur Umwandlung elektrischer Signale in optische Signale und umgekehrt), ein Netzwerkschalter (sog. Network-Switch), ein Netzwerk-Vermittlungsrechner (sog. Network-Router), eine Steckerleiste (sog. Patchfeld), ein Rechensystem in Form eines Computers, insbesondere in Form eines Servers, oder eine Datensicherungseinheit, bspw. ein Bandlaufwerk, um nur einige Beispiele zu nennen. Die in dem Rahmen angeordneten IT-Geräte werden miteinander verschaltet und verkabelt, so dass sie in einem im wesentlichen betriebsbereiten Zustand in dem Behälter vorgehalten werden. In einer Gehäusewand des Behälters sind Anschlüsse für eine Stromversorgung, sowie für Datenleitungen vorgesehen, an welche die IT-Geräte ebenfalls angschlossen sind.

Wenn die in den Behältern angeordneten IT-Geräte in Betrieb sind, ist der Behälter verschlossen, und im Inneren des Behälters wird durch eine Klimaanlage ein gleichmäßiges Klima erzeugt und aufrechterhalten. Das ist wichtig, da die IT-Geräte relativ viel Abwärme erzeugen, die bei durch den Deckel verschlossenem Behälter ohne eine Klimaanlage nicht aus dem Behälter abgeführt werden könnte. Ein Verzicht auf die Klimaanlage durch Öffnen der Behälter, indem einfach der Deckel abgenommen wird, ist in aller Regel nicht möglich, da der Einsatzort der IT-Geräte üblicherweise nicht im Inneren eines sauberen, trockenen und kühlen Gebäude eingesetzt werden, sondern eher in einer ungeschützten Umgebung mit relativ viel Staub, Sand, und Schmutz und relativ hoher Feuchtigkeit und Temperatur liegt, bspw. in einem Zelt in einem Wüstengebiet oder einem Tropengebiet. Aus diesem Grund sind die Behälter zumindest während des Betriebs IT-Geräte nahezu hermetisch abgedichtet. Es wird versucht, die Behälter mindestens nach IP 54 abzudichten.

Während des Betriebs können jedoch bestimmte IT-Geräte Gase erzeugen, die sich im Inneren des Behälters sammeln und eine nicht unbeträchtliche Gefahr darstellen können. Die Akkueinheiten der USVs weisen in der Regel Bleiakkus und eine Kunststoffummantelung auf. Die Akkus erzeugen in einem sehr langsamen Prozess geringe Mengen an Wasserstoff, der langsam durch die Kunststoffummantelung der Akkus hindurch diffundiert und sich im Inneren des Behälters sammelt. Wesentlich größere Mengen an Wasserstoff werden zudem innerhalb relativ kurzer Zeit erzeugt, falls die Akkus überladen werden, bspw. weil die Steuerelektronik der USVs defekt ist. Abgesehen davon, dass die Ansammlung von Wasserstoff oder anderen Gasen im Inneren des Behälters eine große Gefahr für umstehende Personen und die IT-Geräte darstellt (Wasserstoff könnte durch einen Funken explodieren), ist der Betrieb bestimmter IT-Geräte, bspw. der USVs bzw. der Akkueinheit, in geschlossenen Behältern laut VDE-Norm (z.B. VDE 0510) nicht erlaubt. Somit besteht ein Zielkonflikt zwischen einer im wesentlichen hermetischen Abdichtung des Betriebs, Lager- und Transportbehälters und eines Betriebs der im Inneren des Behälters angeordneten IT-Geräte andererseits.

Ausgehend von diesem Stand der Technik liegt der vorliegenden Erfindung die Aufgabe zugrunde einen Betriebs, Lager- und Transportbehälter der eingangs genannten Art dahingehend auszugestalten und weiterzubilden, dass unter Einhaltung der entsprechenden VDE-Normen das Innere des Behälters einerseits wirksam gegen das Eindringen von Staub, Sand, und Schmutz geschützt ist und andererseits ein gleichmäßiges Klima im Inneren des Behälters, insbesondere bezüglich Luftfeuchtigkeit und Temperatur, erzeugt und aufrechterhalten werden kann.

Zur Lösung dieser Aufgabe wird ausgehend von dem Betriebs, Lager- und Transportbehälter der eingangs genannten Art vorgeschlagen, dass
- der Behälter Zufuhrmittel aufweist, um Luft aus der Umgebung des Behälters in das Innere des Behälters zuzuführen, und
- der Behälter Abgabemittel aufweist, um Luft aus dem Inneren des Behälters an die Umgebung des Behälters abzugeben.

Erfindungsgemäß ist erkannt worden, dass zur Erfüllung der einschlägigen VDE-Normen betreffend den Betrieb von IT-Geräten, insbesondere von USVs bzw. von Akkueinheiten, in geschlossenen Behältern die strikte Abschottung des Innenraums des Behälters gegenüber der Umgebung aufgehoben werden muss. Dabei wird nicht einfache die Trennung zwischen Innenraum und Umgebung komplett aufgehoben (bspw. durch Öffnen des Deckels), sondern es wird zunächst die Abschottung des Innenraums im wesentlichen aufrechterhalten und ein sog. Zweikreis-Gerät als Klimaanlage eingesetzt, bei dem kein Luftaustausch zwischen Innenraum und Umgebung stattfindet. Dadurch kann einerseits das Eindringen von Staub, Sand, und Schmutz in das Innere des Behälters verhindert und andererseits ein gleichmäßiges Klima im Inneren des Behälters, insbesondere bezüglich Luftfeuchtigkeit und Temperatur, erzeugt und aufrechterhalten werden. Die Klimaanlage kann an einer beliebigen Wand des Gehäuses oder am Deckel angeordnet sein.

Um den VDE-Norm konformen Betrieb der IT-Geräte im Innenraum zu ermöglichen, wird durch die Zufuhrmittel eine im Vergleich zu der im Innenraum des Behälters pro Zeiteinheit umgewälzten Luftmenge relativ kleine Luftmenge von außerhalb des Behälters zugeführt und durch die Abgabemittel eine entsprechende Luftmenge wieder an die Umgebung abgegeben. Dabei ist es möglich, dass die Zufuhrmittel und die Abgabemittel aktiv die Zufuhr von Außenluft bzw. Abgabe von Luft nach außen bewirken. Es ist allerdings ausreichend, wenn nur die Zufuhrmittel oder nur die Abgabemittel aktiv sind, so dass bei aktiven Zufuhrmitteln die Abgabe von Luft nach außen aufgrund des Überdrucks im Inneren des Behälters bzw. bei aktiven Abgabemitteln die Zufuhr von Außenluft aufgrund des Unterdrucks im Inneren des Behälters von selbst, also ohne Aktivität der Abgabemittel bzw. der Zufuhrmittel erfolgt.

Gemäß einer vorteilhaften Weiterbildung der Erfindung wird vorgeschlagen, dass die Zufuhrmittel derart ausgebildet sind, dass sie aktiv Luft aus der Umgebung des Behälters in das Innere des Behälters zuführen. In diesem Fall sind die Abgabemittel vorzugsweise einfach als mindestens eine Öffnung im Gehäuse des Behälters ausgebildet, durch die Luft aus dem Inneren des Behälters aufgrund der Luftzufuhr durch die Zufuhrmittel in die Umgebung austritt. Durch die Luftzufuhr durch die Zufuhrmittel entsteht im Inneren des Behälters ein Überdruck, der über die Öffnung im Gehäuse abgebaut wird. Die Zufuhrmittel können bspw. als Gebläse oder als Pneumatikpumpe ausgebildet sein. Am Lufteingang der Zufuhrmittel sind vorzugsweise Luftfilter zum Herausfiltern von Staub, Sand, und Schmutz aus der angesaugten Außenluft angeordnet. Die Luftfilter sollten leicht auszutauschen und zu reinigen sein, um geringe Wartungszeiten und damit eine hohe Verfügbarkeit der in dem Behälter angeordneten IT-Geräte bzw. der gesamten Netzwerkstruktur zu ermöglichen.

Gemäß einer bevorzugten Ausführungsform der Erfindung wird vorgeschlagen, dass der Behälter Mittel zum Entfeuchten der in das Innere des Behälters zugeführten Umgebungsluft aufweist. Insbesondere in Einsatzregionen mit hoher Luftfeuchtigkeit, bspw. in den tropischen Regionen, herrscht oft eine Temperatur von um die 55°C und eine Luftfeuchtigkeit von ca. 95% relative Luftfeuchte. Die Außenluft wird von den Zufuhrmittel von außen angesaugt und würde sich an den kühleren IT-Geräten im Innenraum des Behälters niederschlagen. Aus diesem Grund ist eine wirksame Entfeuchtung der angesaugten Außenluft von großer Bedeutung. Die Entfeuchtungsmittel können bspw. als hydrophiles Material (z.B. Silikalgel oder Lithiumchlorid), das am Lufteingang der Zufuhrmittel angeordnet werden kann, oder als elektrische Entfeuchter ausgebildet sein. Vorteilhafterweise dient als Mittel zum Entfeuchten der Umgebungsluft die Klimaanlage des Betriebs, Lager- und Transportbehälters.

Gemäß einer anderen vorteilhaften Weiterbildung der Erfindung wird vorgeschlagen, dass die Zufuhrmittel
- im Inneren des Behälters angeordnete Unterdruckerzeugungsmittel zum zumindest bereichsweise Erzeugen eines Unterdrucks und
- eine in dem Bereich des Unterdrucks angeordnete pneumatische Verbindung zur Umgebung des Behälters aufweisen.
Die pneumatische Verbindung von dem Bereich des Unterdrucks zur Umgebung des Behälters ist vorzugsweise als ein Schlauch ausgebildet, wobei eine erste Öffnung des Schlauchs im Bereich des Unterdrucks angeordnet ist und eine zweite Öffnung des Schlauchs mit der Umgebung des Behälters in Verbindung steht. Durch den Unterdruck wird Luft aus der Umgebung des Behälters in den Innenraum angesaugt und führt dort zumindest bereichsweise zu einem Überdruck, der zur Abgabe von Luft aus dem Innenraum an die Umgebung führt. Dadurch entsteht eine Luftzirkulation zwischen Umgebung und Innenraum des Behälters, durch die Gase aus dem Innenraum in die Umgebung abtransportiert werden.

Gemäß einer weiteren bevorzugten Ausführungsform der Erfindung wird vorgeschlagen, dass die Unterdruckerzeugungsmittel als ein der Klimaanlage zugeordnetes Gebläse zur Zirkulation der Innenluft am Verdampfer vorbei ausgebildet sind. Diese Ausführungsform hat den ganz besonderen Vorteil, dass keine zusätzlichen Unterdruckerzeugungsmittel oder andere Zufuhrmittel vorgesehen werden müssen, sondern dass einfach das bereits vorhandene innere Gebläse der Klimaanlage zum Ansaugen von Außenluft eingesetzt wird. Vorzugsweise ist auf der Ansaugseite des Gebläses eine erste Öffnung eines Schlauchs angeordnet, wobei eine zweite Öffnung des Schlauchs mit der Umgebung des Behälters in Verbindung steht.

Derart ausgestaltete Zufuhrmittel arbeiten nach dem sog. Venturi- bzw. nach dem Gesetz von Bernoullie. Das Gebläse erzeugt auf der Ansaugseite bereichsweise einen Unterdruck und auf der Ausstoßseite bereichsweise einen Überdruck. Wenn nun das eine Ende des Schlauchs in den Bereich des Unterdrucks bebracht wird - wobei der Unterdruck kleiner als der Umgebungsdruck sein muss -, wird über den Schlauch Außenluft angesaugt. Die angesaugte Luft wird dann zunächst über den Verdampfer geführt, bevor sie in den Innenraum des Behälters geblasen wird. Das hat den vorteilhaften Nebeneffekt, dass die Außenluft gleich entfeuchtet wird, was insbesondere beim Einsatz der IT-Geräte in Regionen mit hoher Luftfeuchtigkeit große Vorteile hat. Die angesaugte Luft bewirkt in dem Behälter bereichsweise einen Überdruck, was dazu führt, dass Luft aus dem Inneren des Behälters über eine Öffnung in der Gehäusewand automatisch nach außen abgegeben wird. Die abgegebene Luftmenge/Zeiteinheit entspricht dabei in etwa der von außen angesaugten Luftmenge/Zeiteinheit.

Um eine zu große Beeinflussung der klimatischen Verhältnisse im Inneren des Behälters durch die angesaugte Außenluft zu vermeiden, wird vorgeschlagen, dass die aus der Umgebung des Behälters entnommene Luftmenge/Zeiteinheit kleiner ist als die im Inneren des Behälters zirkulierende Luftmenge/Zeiteinheit. Die von außen entnommene Luftmenge/Zeiteinheit ist vorzugsweise mindestens um den Faktor kleiner als die im Inneren durch das Gebläse umgewälzte Luftmenge/Zeiteinheit. Vorteilhafterweise ist die aus der Umgebung des Behälters entnommene Luftmenge/Zeiteinheit kleiner oder gleich 1% der im Inneren des Behälters zirkulierenden Luftmenge/Zeiteinheit.

Gemäß einer bevorzugten Ausführungsform der Erfindung wird vorgeschlagne, dass der Behälter Einstellmittel zum Einstellen der aus der Umgebung des Behälters entnommenen Luftmenge/Zeiteinheit aufweist. Dadurch kann die von Außen entnommene Luftmenge/Zeiteinheit am Ende der Fertigung des Betriebs, Lager- und Transportbehälters oder während des Betriebs der IT-Geräte auf einen gewünschten Wert eingestellt und an die in der Einsatzregion herrschenden klimatischen Bedingungen bzw. an die Art und Anzahl der im Behälter betriebenen IT-Geräte angepasst werden.

Bevorzugte Ausführungsbeispiele der Erfindung werden nachfolgend anhand der Figuren näher erläutert. Es zeigt:

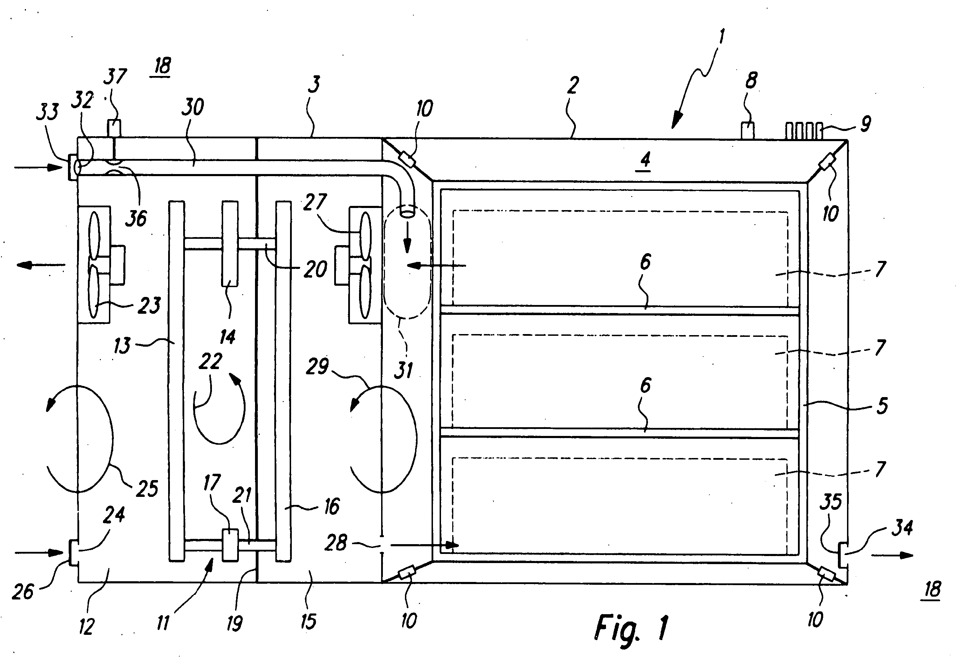

Fig. 1 einen erfindungsgemäßen Betriebs, Lager- und Transportbehälter im Längsschnitt.

Ein erfindungsgemäßer Betriebs, Lager- und Transportbehälter ist in Fig. 1 in seiner Gesamtheit mit dem Bezugszeichen 1 bezeichnet. Der Behälter 1 umfasst ein vorzugsweise quaderförmiges Gehäuse 2 mit mehreren Gehäusewänden. Auf der linken Seite von Fig. 1 weist das Gehäuse eine Öffnung auf, durch welche Informationstechnologie (IT)-Geräte 7 in den Behälter 1 eingebracht werden können und welche durch einen abnehmbaren Deckel 3 verschlossen ist. Der Deckel 3 ist mittels Schnellverschlüsse, bspw. in Form von Bajonettverschlüssen oder Spannverschlüssen, an dem Gehäuse 2 lösbar befestigt. Das Gehäuse 2 und der Deckel 3 sind vorzugsweise aus Aluminium gefertigt. Vorteile von Aluminium sind ein geringes Gewicht und eine gute Beständigkeit gegen Witterungseinflüsse und.chemische Einflüsse.

Im Inneren 4 des Behälters 1 sind Aufnahmemittel in Form eines 19"-Rahmens 5 und mehrerer daran befestigter Auflaufschienen 6 angeordnet. Auf den Auflaufschienen 6 sind die IT-Geräte 7 in den Rahmen 5 eingeschoben und dort befestigt. IT-Geräte 7, die in dem Behälter 1 angeordnet werden können, sind bspw. eine unterbrechungsfreie Stromversorgung (USV) als Einheit oder unterteilt in Steuereinheit und Akkueinheit, ein Datenkomprimierer (zum Komprimieren und wahlweise Verschlüsseln der zu übertragenden Daten), ein Medienwandler (zur Umwandlung elektrischer Signale in optische Signale und umgekehrt), ein Netzwerkschalter (sog. Network-Switch), ein Netzwerk-Vermittlungsrechner (sog. Network-Router), eine Steckerleiste (sog. Patchfeld), ein Rechensystem in Form eines Computers, insbesondere in Form eines Servers, oder eine Datensicherungseinheit, bspw. ein Bandlaufwerk, um nur einige Beispiele zu nennen. Die in dem Rahmen 5 angeordneten IT-Geräte 7 werden miteinander verschaltet und verkabelt, so dass sie in einem im wesentlichen betriebsbereiten Zustand in dem Behälter 1 vorgehalten werden. In einer Wand des Gehäuses 2 sind ein Anschluss 8 für eine Stromversorgung, sowie Anschlüsse 9 für Datenleitungen vorgesehen. Die IT-Geräte 7 sind an die Anschlüsse 8, 9 angeschlossen, so dass durch Anschließen der Stromversorgung und der Datenleitungen an die Anschlüsse 8, 9 die in dem Behälter 1 angeordneten IT-Geräte 7 schnell und unkompliziert in eine bereits bestehende oder noch aufzubauende IT-Infrastruktur integriert werden können. Selbstverständlich können die Anschlüsse 8, 9 auch in dem Deckel 3 ausgebildet sein.

Der Rahmen 5 und die Schienen 6 bestehen bspw. aus Aluminiumprofilen mit einem vorzugsweise L-förmigen Querschnitt. An jeder Ecke des Rahmens 5 sind insgesamt acht Schwingungsdämpfer 10 angeordnet, welche die Aufnahmemittel 5, 6 und die darin angeordneten IT-Geräte 7 vor Stößen schützen. Die Schwingungsdämpfer 10 sind relativ steif ausgelegt, um insbesondere schwere Stöße während des Transports des Behälters 1 zu dämpfen. Die Ausgestaltung der Aufnahmemittel kann beliebig variieren, insbesondere kann die Anzahl und Anordnung der Auflaufschienen 6, die Anzahl, Ausgestaltung und Auslegung der Schwingungsdämpfer 10 von dem dargestellten Ausführungsbeispiel abweichen.

In den Deckel 3 integriert ist eine Klimaanlage 11, die als ein sog. Split-Gerät ausgebildet ist. Die Klimaanlage 11 umfasst eine mit der Umgebung des Behälters 1 in Luftaustausch stehende Außeneinheit 12 mit einem Kondensator 13 und einem Kompressor 14 und eine mit dem Innenraum 4 des Behälters 1 in Luftaustausch stehende Inneneinheit 15 mit einem Verdampfer 16. Außerdem weist die Klimaanlage 11 ein in der Außeneinheit 12 angeordnetes Expansionsventil 17. Die Trennung zwischen der Umgebung 18 und dem Innenraum 4 des Behälters 1 erfolgt durch eine Trennwand 19. Der Kompressor 14 steht über eine erste Verbindungsleitung 20 mit dem Verdampfer 16 in Verbindung. Der Verdampfer 16 steht seinerseits über eine weitere Verbindungsleitung 21 mit dem Expansionsventil 17 in Verbindung. Die beiden Verbindungsleitungen 20, 21 sind vorzugsweise zu einem einzigen Kühlmittelschlauch zusammengefasst, welcher die Außeneinheit 12 mit der Inneneinheit 15 verbindet, um eine Zirkulation 22 von Kühlmittel zwischen der Außeneinheit 12 und der Inneneinheit 15 zu ermöglichen. Das Split-Gerät unterbindet also jeglichen Luftaustauschs zwischen Umgebung 18 und Innenraum 4 des Behälters 1. Dadurch wird eine Klimatisierung des Innenraums 4 auf vorgegebene Klimabedingungen möglich, ohne dass Staub, Sand oder Schmutz aus der Umgebung 18 in den Innenraum 4 eindringen können. Insbesondere wird der Innenraum 4 auf eine Temperatur im Bereich von etwa

Die Funktionsweise der Klimaanlage 11 ist allgemein bekannt und sei hier nur kurz skizziert. In einem geschlossenen Kreislauf verdampft und kondensiert das Kältemittel (meist Ammoniak oder ein Halogenkohlenwasserstoff) und folgt dabei mehreren physikalischen Gesetzmäßigkeiten. Im Verdampfer 16 wird die Luft im Innenraum 4 des Behälters 1 durch Wärmeaustausch mit dem Kältemittel abgekühlt. Das Kältemittel verdampft im Verdampfer 16 bei niedrigem Druck und entzieht dadurch der Luft im Innenraum 4 Wärme. Der Dampf wird dann vom Kompressor 14 angesaugt und verdichtet. Im Kondensator 13 (Verflüssiger) wird der verdichtete Kältemitteldampf unter Wärmeabgabe an die Umgebung verflüssigt und strömt anschließend durch das Expansionsventil 17. Dort wird das Kältemittel auf niedrigen Druck entspannt und fließt wieder in den Verdampfer 16.

Die Klimaanlage 11 umfasst ein erstes dem Kondensator 13 zugeordnetes Gebläse 23 (oder Ventilator oder Lüfter), welches zusammen mit einer Öffnung 24 im Deckel 3 zur Umgebung 18 hin für eine Luftzirkulation 25 zwischen der Umgebung 18 und dem Inneren der Außeneinheit 12 am Kondensator 13 vorbei sorgt. Um das Innere der Außeneinheit 12 vor Staub, Sand oder Schmutz zu schützen, ist die Öffnung 24 durch ein Luftfilter 26 abgedeckt. Des weiteren umfasst die Klimaanlage 11 ein zweites Gebläse 27, welches zusammen mit einer Öffnung 28 zum Innenraum 4 des Behälters 1 hin für eine Luftzirkulation 29 zwischen dem Innenraum 4 und dem Inneren der Inneneinheit 15 am Verdampfer 16 vorbei sorgt. Durch die Luftzirkulation 29 können die vorgegebenen klimatischen Bedingungen im Innenraum 4 wirksam und gleichmäßig erreicht werden.

Der dargestellte Deckel 3 mit der integrierten Klimaanlage 11 wird nur während des stationären Betriebs der IT-Geräte 7 im Einsatzgebiet auf das Gehäuse 2 gesetzt. Während des Transports des Behälters 1 und der darin angeordneten IT-Geräte 7 wird der Klima-Deckel 3 abgenommen und durch einen Transportdeckel (nicht dargestellt) ersetzt, welcher die nach Abnahme des Klima-Deckels 3 entstandene Öffnung des Behälters 1 einfach wieder verschließt. Der Transportdeckel wird ebenfalls mittels Schnellverschlüsse, bspw. in Form von Bajonettverschlüssen oder Spannverschlüssen, an dem Gehäuse 2 lösbar befestigt. Der Klima-Deckel 3 wird, wahlweise zusammen mit der Akkueinheit einer in dem Behälter 1 angeordneten USV, in einem separaten Transportbehälter (nicht dargestellt) transportiert.

Um im Innenraum 4 des Behälters 1 auch solche IT-Geräte gefahrlos und vor allem VDE-konform betreiben zu können, welche im Betrieb ausgasen können, wird erfindungsgemäß vorgeschlagen, eine kleine Luftmenge/Zeiteinheit aus der Umgebung 18 zu entnehmen, in den Innenraum 4 zu leiten und in etwa eine entsprechende Luftmenge/Zeiteinheit aus dem Innenraum 4 zu entnehmen und an die Umgebung 18 abzugeben, so dass sich ein mengenmäßig kleiner Luftaustausch zwischen der Umgebung 18 und dem Innenraum 4 einstellt. Dieser reicht aus, um während des Betriebs der IT-Geräte 7 entstehende Gase aus dem Innenraum 4 wirksam in die Umgebung 18 abzuleiten. Andererseits ist der Luftaustausch so klein, dass durch ihn die klimatischen Bedingungen im Innenraum 4 kaum beeinträchtigt werden. Die Beeinträchtigung ist jedenfalls so gering, dass daraus resultierende Klimaänderungen durch die Klimaanlage 11 unmittelbar und ohne große Anstrengung kompensiert werden können. Gemäß der Erfindung wird also die bisherige strikte Trennung von Umgebung 18 und Innenraum 4 durch das Split-Gerät 11 zu einem ganz geringen Grad bewusst aufgehoben.

In dem Deckel 3 des Behälters 1 ist ein Schlauch oder eine Leitung 30 angeordnet, die an ihren beiden distalen Enden jeweils eine Öffnung aufweist. Als Zufuhrmittel für die Außenluft werden bereits vorhandene Aggregate genutzt. Das zweite Gebläse 27 sorgt im Betrieb auf der Ansaugseite in einem beispielhaft eingezeichneten und mit dem Bezugszeichen 31 bezeichneten Bereich für einen bereichsweisen Unterdruck in dem Innenraum 4. Der Druck in dem Bereich 31 ist geringer als in der Umgebung 18 des Behälters 1; deshalb spricht man von Unterdruck. In diesen Unterdruckbereich 31 wird ein Ende des Schlauchs 30 angeordnet. Das andere Ende des Schlauchs 30 ist an eine Öffnung 32 im Deckel 3 geführt, welche mit der Umgebung 18 in Verbindung steht. Selbstverständlich könnte die Öffnung 32 auch im Gehäuse 2 ausgebildet sein. Die Öffnung 32 ist durch ein Luftfilter 33 abgedeckt. Durch die Druckdifferenz zwischen dem Bereich 31 und der Umgebung 18 bildet sich ein Luftstrom in dem Schlauch 30, durch den Umgebungsluft in den Innenraum 4 des Behälters 1 gesaugt wird.

Die angesaugte Außenluft wird dann durch das Gebläse 27 angesaugt und an dem Verdampfer 16 entlang geführt, was eine Entfeuchtung der Außenluft bewirkt. Erst danach wird die Außenluft entfeuchtete Außenluft durch die Öffnung 28 in den Innenraum 4 des Behälters 1 geblasen. Dort stellt sich dann durch die zugeführte Umgebungsluft bereichsweise ein Überdruck ein, das heißt ein Druck, der oberhalb des in der Umgebung 18 herrschenden Drucks liegt. Durch diesen Druck wird ein Teil der im Innenraum 4 zirkulierenden Luft durch eine Öffnung 34 im Gehäuse 2 in die Umgebung 18 ausgeblasen. Um das Eindringen von Staub, Sand, Schmutz oder Insekten entgegen der Strömungsrichtung zu vermeiden, ist die Öffnung 34 durch ein Luftfilter 35 abgedeckt. Zusätzlich zu der Luftzirkulation 29 stellt sich also im Innenraum eine zusätzliche, relativ kleine Luftzirkulation von der Umgebung 18, durch die Öffnung 32, durch den Schlauch 30, durch die Inneneinheit 15, in den Innenraum 4 und durch die Öffnung 34 wieder zurück in die Umgebung 18 ein. Dabei muss betont werden, dass eine strikte Trennung der internen Luftzirkulation 29 und der zusätzlichen Luftzirkulation nicht möglich ist, so dass in der Praxis Außenluft auch intern zirkulieren und Luft der Luftzirkulation 29 durch die Öffnung 34 in die Umgebung 18 ausgeblasen werden kann.

In dem Schlauch 30 oder in der Öffnung 32 sind verstellbare Drosselmittel 36 vorgesehen, welche durch außerhalb des Behälters 1 angeordnete Betätigungsmittel 37 betätigt werden können. Selbstverständlich können die Betätigungsmittel 37 auch im Inneren des Deckels 3, bspw. in der Außeneinheit 12 oder in der Inneneinheit 15, angeordnet sein, so dass sie nur bei abgenommenem Deckel 3 betätigt werden können. Durch die Drosselmittel 36 kann die durch den Schlauch strömende Luftmenge/Zeiteinheit unabhängig von der Drehzahl des Gebläses 27 und damit unabhängig von der Größe des Unterdrucks in dem Bereich 31 auf einen gewünschten Wert eingestellt werden.

Um eine zu große Beeinflussung der klimatischen Verhältnisse im Innenraum 4 des Behälters 1 durch die angesaugte Außenluft zu vermeiden, ist die aus der Umgebung 18 des Behälters 1 entnommene Luftmenge/Zeiteinheit deutlich kleiner als die im Innenraum 4 zirkulierende Luftmenge/Zeiteinheit. Die von außen entnommene Luftmenge/Zeiteinheit ist vorzugsweise kleiner oder gleich 1% der im Inneren des Behälters 1 zirkulierenden Luftmenge/Zeiteinheit. Die im inneren zirkulierende Luftmenge beträgt beispielsweise 600 m³/h. Eine geeignete Luftmenge für die angesaugte Außenluft beträgt dann beispielsweise 1 m³/h oder sogar noch weniger.

Im Innenraum 4 des Behälters 1 kann noch eine Heizung (nicht dargestellt) vorgesehen sein, um nach einem Transport des Behälters 1 bei niedrigen Temperaturen zum Betrieb der IT-Geräte 7 den Innenraum 4 möglichst rasch wieder auf das für den Betrieb der IT-Geräte 7 vorgesehene Temperaturfenster zu erwärmen. Das Aufheizen des Innenraums 4 kann durch den Betrieb des Gebläses 27 beschleunigt werden. Selbstverständlich kann der Behälter 1 mehr als nur einen Deckel aufweisen. Insbesondere kann der Behälter 1 jeweils einen Deckel an der Vorderseite und an der Rückseite des Behälters 1 aufweisen. Wahlweise können auch mehrere Deckel mit einer Klimaanlage 11 ausgerüstet sein. Außerdem können mehrere Deckel auf einer Seite des Behälters 1 angeordnet sein. Der Behälter 1 weist an seiner Außenseite, vorzugsweise an zwei gegenüberliegenden Seiten, klappbare Haltegriffe (nicht dargestellt) auf, an denen der Behälter 1 zum Transport von Personen fest und sicher ergriffen und angehoben werden kann. Vorzugsweise sind auf jeder Seite zwei Haltegriffe vorgesehen, so dass die Kiste von insgesamt vier Personen angehoben und transportiert werden kann. An der Unterseite der Kiste können höhenverstellbare Füße (nicht dargestellt) vorgesehen sein, um einen sicheren Stand des Behälters 1 sicherzustellen. In einer Wand des Behälters 1 können außerdem Druckausgleichsmittel (nicht dargestellt) angeordnet sein, um Druckschwankungen während des Transports des Behälters 1 ausgleichen zu können und damit ein Verformen des Behälters 1 aufgrund von Druckdifferenzen zwischen Innenraum 4 und Umgebung 18 zu vermeiden.

## Patentansprüche

1. Betriebs, Lager- und Transportbehälter (1) für Informationstechnologie (IT)-Geräte (7), umfassend:
- ein verschließbares Gehäuse (2) mit mindestens einem abnehmbaren Deckel (3),
- in dem Gehäuse (3) angeordnete Aufnahmemittel (5, 6, 10) für die IT-Geräte (7) und
- eine Klimaanlage (11) zur Erzeugung und Aufrechterhaltung eines gleichmäßigen Klimas im Innenraum (4) des Behälters (1), wobei
- die Klimaanlage (11) eine mit der Umgebung (18) des Behälters (1) in Luftaustausch stehende Außeneinheit (12) mit einem Kondensator (13) und einem Kompressor (14) und eine mit dem Innenraum (4) des Behälters (1) in Luftaustausch stehende Inneneinheit (15) mit einem Verdampfer (16) aufweist, wobei die Außeneinheit (12) über einen Kühlmittelschlauch (20, 21) mit der Inneneinheit (15) verbunden ist, um eine Zirkulation von Kühlmittel zwischen Außeneinheit (12) und Inneneinheit (15) zu ermöglichen,
**dadurch gekennzeichnet, dass**
- der Behälter (1) Zufuhrmittel (27, 30, 32) aufweist, um Luft aus der Umgebung (18) des Behälters (1) in den Innenraum (4) des Behälters (1) zuzuführen, wobei die Zufuhrmittel (27, 30, 32) im Innenraum (4) des Behälters (1) angeordnete Unterdruckerzeugungsmittel (27) zum zumindest bereichsweise Erzeugen eines Unterdrucks und eine in dem Bereich (31) des Unterdrucks angeordnete pneumatische Verbindung (30) zur Umgebung (18) des Behälters (1) umfassen, und
- der Behälter (1) Abgabemittel (34) aufweist, um Luft aus dem Innenraum (4) des Behälters (1) an die Umgebung (18) des Behälters (1) abzugeben, wobei die Abgabemittel (34) mindestens eine Öffnung im Gehäuse (2) des Behälters (1) umfassen, durch die Luft aus dem Inneren des Behälters (1) aufgrund der Luftzufuhr durch die Zufuhrmittel (27, 30, 32) in die Umgebung (18) austritt.

2. Betriebs, Lager- und Transportbehälter (1) nach Anspruch 1, **dadurch gekennzeichnet, dass** der Behälter (1) Mittel zum Entfeuchten der in das Innere des Behälters (1) zugeführten Umgebungsluft aufweist.

3. Betriebs, Lager- und Transportbehälter (1) nach Anspruch 2, **dadurch gekennzeichnet, dass** als Mittel zum Entfeuchten der Umgebungsluft die Klimaanlage (11) dient.

4. Betriebs, Lager- und Transportbehälter (1) nach einem der Ansprüche 1 bis 3, **dadurch gekennzeichnet, dass** die pneumatische Verbindung (30) von dem Bereich (31) des Unterdrucks zur Umgebung (18) des Behälters (1) als ein Schlauch ausgebildet ist, wobei eine erste Öffnung des Schlauchs (30) im Bereich (31) des Unterdrucks angeordnet ist und eine zweite Öffnung des Schlauchs mit der Umgebung (18) des Behälters (1) in Verbindung steht.

5. Betriebs, Lager- und Transportbehälter (1) nach einem der Ansprüche 1 bis 4, **dadurch gekennzeichnet, dass** die Unterdruckerzeugungsmittel als ein der Klimaanlage (11) zugeordnetes Gebläse (27) zur Zirkulation der Innenluft am Verdampfer (16) vorbei ausgebildet sind.

6. Betriebs, Lager- und Transportbehälter (1) nach Anspruch 5, **dadurch gekennzeichnet, dass** auf der Ansaugseite des Gebläses (27) eine erste Öffnung eines Schlauchs (30) angeordnet ist, wobei eine zweite Öffnung des Schlauchs (30) mit der Umgebung (18) des Behälters (1) in Verbindung steht.

7. Betriebs, Lager- und Transportbehälter (1) nach einem der Ansprüche 1 bis 6, **dadurch gekennzeichnet, dass** die aus der Umgebung (18) des Behälters (1) entnommene Luftmenge pro Zeiteinheit kleiner ist als die im Innenraum (4) des Behälters (1) zirkulierende Luftmenge pro Zeiteinheit.

8. Betriebs, Lager- und Transportbehälter (1) nach Anspruch 7, **dadurch gekennzeichnet, dass** die aus der Umgebung (18) des Behälters (1) entnommene Luftmenge pro Zeiteinheit kleiner oder gleich 1% der im Innenraum (4) des Behälters (1) zirkulierenden Luftmenge pro Zeiteinheit ist.

9. Betriebs, Lager- und Transportbehälter (1) nach einem der Ansprüche 1 bis 8, **dadurch gekennzeichnet, dass** der Behälter (1) Einstellmittel (36, 37) zum Einstellen der aus der Umgebung (18) des Behälters (1) entnommenen Luftmenge pro Zeiteinheit aufweist.

## Claims

1. An operating, storage and transport container (1) for information technology (IT) devices (7), comprising
- a lockable housing (2) with at least one removable cover (3),
- storage means (5, 6, 10) for the IT devices (7) arranged in the housing (2), and
- an air-conditioning installation (11) for generating and maintaining an even climate in the interior (4) of the container (1), wherein
- the air-conditioning installation (11) has an exterior unit (12), which provides an air exchange with the surroundings (18) of the container (1) and has a condenser (13) and a compressor (14), and an interior unit (15) providing an air exchange with the interior (4) of the container (1) and which has an evaporator (16), wherein the exterior unit (12) is connected with the interior unit (15) via a coolant hose (20, 21) in order to make possible the circulation of coolant between the exterior unit (12) and the interior unit (15),
**characterized in that**
- the container (1) has supply means (27, 30, 32) for providing air from the surroundings (18) of the container (1) to the interior (4) of the container (1), wherein the supply means (27, 30, 32) comprise underpressure generating means (27) arranged in the interior (4) of the container (1) for generating an underpressure at least in some areas, and a pneumatic connection (30) with the surroundings (18) of the container (1), arranged in the area (31) of underpressure, and
- the container (1) has conveying means (34) for conveying air from the interior (4) of the container (1) to the surroundings (18) of the container (1), wherein the conveying means (34) comprise at least one opening in the housing (2) of the container (1), through which the air from the interior of the container (1) exits to the surroundings (18) because of the air provided by the supply means (27, 30, 32).

2. The operating, storage and transport container (1) in accordance with claim 1, **characterized in that** the container (1) has means for dehumidifying the ambient air supplied to the interior of the container (1).

3. The operating, storage and transport container (1) in accordance with claim 2, **characterized in that** the air-conditioning installation (11) is used for dehumidifying the ambient air.

4. The operating, storage and transport container (1) in accordance with one of claims 1 to 3, **characterized in that** the pneumatic connection (30) from the area (31) of underpressure to the surroundings (18) of the container (1) is embodied as a hose, wherein a first opening of the hose (30) is arranged in the area (31) of underpressure, and a second opening of the hose is connected with the surroundings (18) of the container (1).

5. The operating, storage and transport container (1) in accordance with one of claims 1 to 4, **characterized in that** the underpressure generating means are embodied as a blower (27) assigned to the air-conditioning installation (11) for circulating the interior air past the evaporator (16).

6. The operating, storage and transport container (1) in accordance with claim 5, **characterized in that** a first opening of a hose (30) is arranged on the aspirating side of the blower (21), wherein a second opening of the hose (30) is connected with the surroundings (18) of the container.

7. The operating, storage and transport container (1) in accordance with one of claims 1 to 6, **characterized in that** the amount of air per unit of time taken from the surroundings (18) of the container (1) is less than the amount of air per unit of time circulating in the interior (4) of the container (1).

8. The operating, storage and transport container (1) in accordance with claim 7, **characterized in that** the amount of air per unit of time taken from the surroundings (18) of the container (1) is less than or equal to 1% of the amount of air per unit of time circulating in the interior (4) of the container (1).

9. The operating, storage and transport container (1) in accordance with one of claims 1 to 8, **characterized in that** the container (1) has setting means (36, 37) for setting the amount of air per unit of time taken from the surroundings (18) of the container (1).

## Revendications

1. Contenant de fonctionnement, de stockage et de transport (1) pour appareils de technologie de l'information (TI) (7), comportant :
- un boîtier (2) pouvant être fermé comprenant au moins un couvercle (3) amovible,
- des moyens de réception (5, 6, 10) disposés dans le boîtier (7) pour les appareils de TI (7) et
- un climatiseur (11) destiné à générer et conserver un climat uniforme dans l'espace intérieur (4) du contenant (1),
- le climatiseur (11) comprenant une unité extérieure (12) échangeant l'air avec l'atmosphère (18) du contenant (1) et dotée d'un condensateur (13) et d'un compresseur (14) et une unité intérieure (15) échangeant l'air avec l'espace intérieur (4) du contenant (1) et dotée d'un évaporateur (16), l'unité extérieure (12) étant reliée par un tuyau de réfrigérant (20, 21) à l'unité intérieure (15), afin de permettre une circulation du réfrigérant entre l'unité extérieure (12) et l'unité intérieure (15)
**caractérisé en ce que**
- le contenant (1) comprend des moyens d'amenée (27, 30, 32) afin d'amener l'air provenant de l'atmosphère (18) du contenant (1) dans l'espace intérieur (4) du contenant (1), les moyens d'amenée (27, 30, 32) comportant des moyens de génération de dépression (27) disposés dans l'espace intérieur (4) du contenant (1) et destinés à générer au moins par zones une dépression et une liaison pneumatique (30) disposée dans la zone (31) de la dépression par rapport à l'atmosphère (18) du contenant (1), et
- le contenant (1) comprend des moyens de distribution (34) afin de distribuer l'air provenant de l'espace intérieur (4) du contenant (1) vers l'atmosphère (18) du contenant (1), les moyens de distribution (34) comportant au moins une ouverture dans le boîtier (2) du contenant (1) à travers laquelle l'air provenant de l'intérieur du contenant (1) en raison de l'amenée d'air provoquée par les moyens d'amenée (27, 30, 32) sort dans l'atmosphère (18).

2. Contenant de fonctionnement, de stockage et de transport (1) selon la revendication 1, **caractérisé en ce que** le contenant (1) comprend des moyens destinés à déshumidifier l'air ambiant amené à l'intérieur du contenant (1).

3. Contenant de fonctionnement, de stockage et de transport (1) selon la revendication 2, **caractérisé en ce que** le climatiseur (11) sert de moyens destinés à déshumidifier l'air ambiant.

4. Contenant de fonctionnement, de stockage et de transport (1) selon l'une des revendications 1 à 3, **caractérisé en ce que** la liaison pneumatique (30) de la zone (31) de la dépression par rapport à l'atmosphère (18) du contenant (1) est conçue comme un tuyau, une première ouverture du tuyau (30) étant disposée dans la zone (31) de la dépression et une seconde ouverture du tuyau étant reliée à l'atmosphère (18) du contenant (1).

5. Conteneur de fonctionnement, de stockage et de transport (1) selon l'une quelconque des revendications 1 à 4, **caractérisé en ce que** les moyens de génération de dépression sont conçus comme une soufflante (27) associée au climatiseur (11) et destinée à faire circuler l'air intérieur devant l'évaporateur (16).

6. Contenant de fonctionnement, de stockage et de transport (1) selon la revendication 5, **caractérisé en ce qu'**une première ouverture d'un tuyau (30) est disposée sur le côté d'aspiration de la soufflante (27), une seconde ouverture du tuyau (39) étant reliée à l'atmosphère (18) du contenant (1).

7. Contenant de fonctionnement, de stockage et de transport (1) selon l'une des revendications 1 à 6, **caractérisé en ce que** la quantité d'air par unité de temps prélevée de l'atmosphère (18) du contenant (1) est inférieure à la quantité d'air par unité de temps circulant dans l'espace intérieur (4) du contenant (1).

8. Contenant de fonctionnement, de stockage et de transport (1) selon la revendication 7, **caractérisé en ce que** la quantité d'air par unité de temps prélevée de l'atmosphère (18) du contenant (1) est inférieure ou égale à 1% de la quantité d'air par unité de temps circulant dans l'espace intérieur (4) du contenant (1).

9. Contenant de fonctionnement, de stockage et de transport (1) selon l'une des revendications 1 à 8, **caractérisé en ce que** le contenant (1) comprend des moyens de réglage (36, 37) destinés à régler la quantité d'air par unité de temps prélevée de l'atmosphère (18) du contenant (1).
